Europäisches Patentamt

European Patent Office

Office européen des brevets

(11) Publication number: **0 519 156 A1**

## EUROPEAN PATENT APPLICATION

(21) Application number: **92102151.5**

(22) Date of filing: **10.02.92**

(51) Int. Cl.5: **H03K 17/08**, B60R 16/02

(30) Priority: **18.02.91 IT MI91409**

(43) Date of publication of application:
**23.12.92 Bulletin 92/52**

(84) Designated Contracting States:
**DE FR GB NL**

(71) Applicant: **SGS-THOMSON MICROELECTRONICS s.r.l.**
**Via C. Olivetti, 2**
**I-20041 Agrate Brianza Milano(IT)**

(72) Inventor: **Colandrea, Francesco**
**Residenza Cantore 131, Milano 2**
**I-20090 Segrate (Milano)(IT)**
Inventor: **Poletto, Vanni**
**Via Serra 82**
**I-15020 Camino (Alessandria)(IT)**

(74) Representative: **Modiano, Guido et al**
**c/o Modiano & Associati S.r.l. Via Meravigli, 16**
**I-20123 Milano(IT)**

(54) **Ground loss protection device particularly for mos integrated circuits.**

(57) Ground loss protection device particularly for MOS integrated circuits which comprises a high-side driver device (10) which has an input terminal (15), a substrate (11) connected to the ground and an output terminal (12) for driving loads (13) which are external to the high-side driver device (10). The output terminal (12) is provided by means of the source terminal of a MOS transistor (17). At least one terminal of a load (13) is connected to the output terminal (12) and the other terminal of the load (13) is connected to the ground. The protection device comprises at least one diode (14) which connects the substrate (11) to the output terminal (12). The diode (14) connects the substrate (11) to the ground through the load (13) if the ground connection of the substrate (11) is interrupted.

FIG. 4

The present invention relates to a ground loss protection device particularly for high-side driver MOS devices.

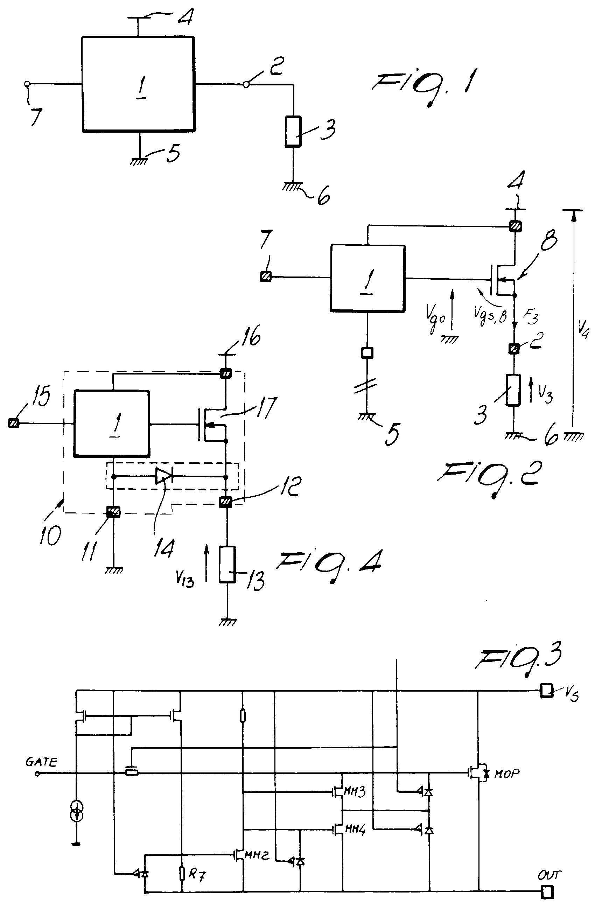

A high-side driver device 1, as more clearly illustrated in figure 1, is connected by means of an output pin 2 to a terminal of a load 3 whose other terminal is connected to the negative pole of a power supply 4. This negative pole is considered hereinafter as a ground 6 for the sake of simplicity in exposition.

The ground connection 5 of the high-side driver device 1 is often physically distant from the ground 6 of the load 3. A typical example is an electronic device for switching on the lights of a motor vehicle. In this example, the ground 6 of the lamps, which are considered similar to the load 3, is physically distant from the ground of the high-side driver circuit 1 which drives them. The circuit 1 is usually included in a control unit which concentrates the electronic components for controlling the entire motor vehicle and is usually located at a considerable distance from the lamps of the motor vehicle.

In the case of a monolithic integrated circuit with high-side driver devices in MOS technology, i.e. devices executed by means of N-channel MOSFET transistors of the enhancement type, the problem arises of the behavior of the high-side driver device 1 if the connection between the device and its ground 6 is interrupted.

If this connection between the device 1 and the ground 6 is interrupted, said device remains hung or rather electrically connected to the power supply voltage 4, and all the internal nodes of the device reach the electric potential of the power supply, except for the nodes which are directly connected to an input 7, which are tied to the potential assumed by the input pin 7.

In this case, as illustrated in figure 2, wherein the same reference numerals used in figure 1 are reused, the gate terminal of a MOS transistor 8 of the high-side driver device 1 might thus reach the same electric potential as the power supply 4 and, since the load 3 is connected to the ground 6, the device 1 might activate or rather supply power to the load 3 although that the signal in input to the terminal 7 of the device 1 is at a level which activates the switching off of the load 3.

The gate terminal of the transistor 8 is at a voltage which is equal to the supply voltage $V_4$, and simultaneously the voltage $V_3$ across the load 3 rises as the current $I_3$ which flows in the load 3 rises. In any case according to the impedance of the load 3, a working point is reached which is given by the following equations, where $V_{th}$ is the threshold voltage of the transistor 8, $V_{GS,8}$ is the voltage between the source terminal and the gate terminal of the transistor 8, $V_{DS,8}$ is the voltage between the drain terminal and the source terminal of the transistor 8, and $V_{GO}$ is the potential of the gate terminal of the transistor 8 with respect to the ground.

Thus, if

$$(V_4 - V_3) > V_{th}$$

then

$$V_{GO} = V_{GS,8} + V_3 = V_4 \qquad (R1)$$

and

$$V_4 = V_{DS,8} + V_3 \qquad \textbf{(R2)}.$$

Equations R1 and R2 therefore lead to the following result:

$$V_{GS,8} = V_{DS,8}.$$

Therefore, the following inequality is true:

$$V_{GS,8} < V_{DS,8} + V_{th} \qquad \textbf{(R3)}.$$

The MOS transistor 8 is thus in the saturation area and must dissipate a power $P_D$ which is equal to:

$$P_D = V_{DS,8} * I_3.$$

This last fact can damage the device 1, since by not having a ground it is no longer protected by any of the circuits present, i.e. by current limiting circuits.

Ground loss would therefore entail not only an unwanted switching on of the device 1 but also the risk of damage thereto.

Usually rather complicated and sometimes scarcely effective solutions are currently used in order to obviate this problem. These known solutions are based on the concept of limiting, precisely in the case of ground loss on the part of the device, the gate-source voltage $V_{GS,8}$ to a value below the threshold value $V_{th}$ of the MOS transistor 8, thus preventing it from switching on.

Such solutions, like the one illustrated in figure 3, are in any case technically not excessively reliable, since the device 1 has no ground; in other words, the substrate on which the device itself is produced monolithically is not biased, i.e. the junctions toward the substrate which are associated with the various electronic components of the circuit are not reverse biased.

The aim of the present invention is to eliminate or substantially reduce the disadvantages described above in known types of high-side driver by providing a ground loss protection device particularly for MOS integrated circuits which eliminates the possibility of incorrect activation of the loads connected to the high-side driver even if the ground connection of said high-side driver is interrupted.

Within the scope of this aim, an object of the present invention is to provide a protection device which eliminates the possibility of damage to the output stage of the high-side driver.

Another object of the present invention is to provide a protection device which has a correct substrate bias even in case of ground loss.

A further object of the present invention is to provide a protection device which can be easily integrated monolithically.

Not least object of the present invention is to provide a protection device which is relatively easy to manufacture and at competitive costs.

This aim, the objects mentioned and others which will become apparent hereinafter are achieved by a ground loss protection device particularly for MOS integrated circuits according to the invention, which comprises a high-side driver device which has an input terminal, a substrate connected to the ground and an output terminal for driving loads which are external to said high-side driver device, said output terminal being provided by means of the source terminal of a MOS transistor, a terminal of a load being connected to said output terminal, the other terminal of said load being connected to the ground, wherein the high-side device driver comprises at least one diode which connects said substrate to said output terminal and is suitable for connecting said substrate to the ground through the load if the ground connection of said substrate is interrupted.

Further characteristics and advantages of the invention will become apparent from the description of a preferred but not exclusive embodiment of a protection device according to the invention, illustrated only by way of non-limitative example in the accompanying drawings, wherein:

figure 1 is a circuit diagram of a known high-side driver;

figure 2 is a circuit diagram of a known high-side driver, illustrating the output stage;

figure 3 is a schematic example of a known high-side driver with reduction of the gate-source voltage across the output MOS transistor; and

figure 4 is a circuit diagram of a protection device according to the invention.

With reference to figure 4, a ground loss protection device particularly for MOS integrated circuits comprises a high-side driver device, generally designated by the reference numeral 10 and hereinafter termed "circuit" for the sake of simplicity in exposition, which has an input terminal 15, a substrate 11 connected to the ground and an output terminal 12 for driving external loads 13 which is provided by means of the source terminal of a MOS transistor 17. At least one terminal of a load 13 is furthermore connected to the output terminal 12; the other terminal of said load is connected to the ground.

The protection device comprises at least one diode 14 which connects the substrate 11 to the output terminal 12 which is connected to the load 13, so as to connect said substrate to the ground of the load 13 if the ground connection of the substrate 11 is interrupted.

The diode 14 has its anode connected to the substrate 11 and its cathode connected to the output terminal 12.

If the ground connection of the circuit 10 is interrupted, said circuit obtains, by means of the connection provided by the diode 14, a negative supply voltage, ignoring the drop across the diode 14, which is equal to the voltage across the load 13. The voltage drop across the load 13 caused by the current absorbed by the circuit 10 usually has a negligible value.

When the direct substrate-ground connection is interrupted, if the electrical command in input to the input terminal 15 is inactive, the circuit 10 remains off and the voltage across the load 13 is zero. The circuit 10 has a real ground, i.e. the ground of the load 13, and is perfectly functional in all of its parts. If instead the electrical command in input to the input terminal 15 is active, the circuit 10 switches on and the voltage across the load rises up to a value which is lower than the supply voltage, which is provided to the circuit 10 and to the load 13 by a power supply 16, by an amount which is at least equal to the threshold voltage of the MOS transistor 17; in other words, a condition of reduced switching "on" with respect to the normal case, in which $V_{13}$ is approximately equal to $V_{16}$.

With respect to the previously described prior art, the circuit 10 is thus fully powered between the supply voltage and the voltage across the load 13, and this fact allows the operation of all of the possible circuits for protecting the circuit 10, i.e. thermal protection circuits and the like (not illustrated) conveniently adapted to the present device.

It is also possible to use protections which inhibit the gate-source voltage, as described in the part related to the prior art, since the present device correctly biases the substrate 11 of the circuit 10.

In the case of high side multidriver monolithic integrated circuits, i.e. integrated circuits having a plurality of individual high-side drivers 10, the protection for each circuit 10 can be provided by means of at least one protection diode 14 interposed between the substrate 11 of the monolithic integrated circuit and the output terminal 12 of each circuit 10.

In this case there is the further advantage that so long as at least one high-side driver is off, the device has a real connection to the ground, allowing the complete switching on of the activated high-side drivers.

If instead all the drivers are on, a condition similar to the case of a device with a single driver would occur, i.e. reduced switching "on" of all the drivers with operating protection circuits would occur.

It has been observed that the present device achieves the intended aim and objects, thus providing an effective protection of a high-side driver and furthermore correctly biasing the substrate of said high-side driver even if the direct connection between the substrate and the ground ceases.

The device thus conceived is susceptible to numerous modifications and variations, all of which are within the scope of the inventive concept. All the details may furthermore be replaced with other technically equivalent elements.

In practice, the materials employed, as well as the dimensions, may be any according to the requirements.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1.  Ground loss protection device particularly for MOS integrated circuits, comprising a high-side driver device (10) which has an input terminal (15), a substrate (11) connected to the ground and an output terminal (12) for driving loads which are external to said high-side driver device (10), said output terminal (12) being provided by means of the source terminal of a MOS transistor (17), at least one terminal of a load (13) being connected to said output terminal (12), the other terminal of said load (13) being connected to the ground, characterized in that said device driver (10) comprises at least one diode (14) which connects said substrate (11) to said output terminal (12) and is suitable for connecting said substrate (11) to the ground through the load (13) if the ground connection of said substrate (11) is interrupted.

2.  Protection device according to claim 1, characterized in that said at least one diode (14) has its anode connected to said substrate (11) and its cathode connected to said output terminal (12).

3.  High-side multidriver device, characterized in that it comprises, for each individual high-side driver (10), at least one protection diode (14) which is interposed between a substrate (11) of said high side multidriver device and the output terminal (12) of said individual high-side driver.

4.  Protection device according to one or more of the preceding claims, characterized in that said at least one diode (14) is provided by means of a diode-connected transistor.

Fig. 1

Fig. 2

Fig. 4

Fig. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 725 912 (R.S. WRATHALL) <br> * whole document * | 1,2 | H 03 K 17/08 <br> B 60 R 16/02 |
| A | PATENT ABSTRACTS OF JAPAN vol. 11, no 74 (M-568)(2521), 6 March 1987; & JP - A - 61229638 (NISSAN MOTOR CO LTD) 13.10.1986 | 1,2 | |
| A | US-A-4 808 839 (W.C. DUNN et al.) <br> * figure 1; column 5, lines 56-61 * | 1 | |
| A | EP-A-0 239 862 (SIEMENS AKTIENGESELLSCHAFT) <br> * figure; abstract * | 1 | |
| A | EP-A-0 358 924 (HELLA KG HUECK & CO) <br> * figure; abstract * | 1 | |
| P,A | EP-A-0 426 103 (KABUSHIKI KAISHA TOSHIBA) <br> * figure 2; abstract * | 1 | |
| A | SIEMENS COMPONENTS vol. 24, no. 5, October 1989, pages 199-201, Berlin, DE; H. RABL: "Power Supply for SIPMOS Transistors or TEMPFETS used as power switches" | | TECHNICAL FIELDS SEARCHED (Int. Cl.5) <br><br> B 60 R 16/02 <br> H 02 H 5/10 <br> H 03 K 17/08 <br> H 03 K 19/003 |
| A | SIEMENS FORSCHUNGS- UND ENTWICKLUGNSBERICHTE vol. 17, no. 1, 1988, pages 35-42, Berlin, DE; J. TIHANYI: "Smart SIPMOS Technology" | | |
| A | EP-A-0 319 047 (NISSAN MOTOR CO LTD) | | |

The present search report has been drawn up for all claims

| Place of search | Date of completion of the search | Examiner |
|---|---|---|
| BERLIN | 12-03-1992 | ARENDT M |